# EUROPÄISCHE PATENTSCHRIFT

(11) **EP 0 712 360 B1**
(45) Veröffentlichungstag und Bekanntmachung des Hinweises auf die Patenterteilung: **05.03.1997**
(21) Anmeldenummer: 94924740.7
(22) Anmeldetag: 12.07.1994
(51) Int. Cl.: B60T 8/88

(54) **REGELSCHALTUNG FÜR BREMSANLAGEN MIT ABS UND/ODER ASR**
CIRCUITRY FOR REGULATING BRAKING SYSTEMS WITH AN ANTILOCKING SYSTEM AND/OR A DRIVE SLIP CONTROL
CIRCUIT DE REGULATION DE SYSTEMES DE FREINAGE A ANTIBLOCAGE AUTOMATIQUE ET/OU A SYSTEME ANTI-PATINAGE A L'ACCELERATION

(30) Priorität: 11.08.1993 DE 4326919
(43) Veröffentlichungstag der Anmeldung: 22.05.1996
(73) Patentinhaber: ITT Automotive Europe GmbH, 60488 Frankfurt am Main (DE)
(72) Erfinder: ESSELBRÜGGE, Hermann, D-64331 Weiterstadt (DE); KANT, Bernhard, D-65239 Hochheim (DE); KRANZ, Thomas, D-61191 Rosbach (DE)
(74) Vertreter: Blum, Klaus-Dieter, Dipl.-Ing.
(86) Internationale Anmeldenummer: EP9402274
(87) Internationale Veröffentlichungsnummer: WO9504674

(56) Entgegenhaltungen:
- EP-A- 0 357 922
- WO-A-90/02066
- WO-A-90/03602
- ATZ, Bd.93, Nr.7/8, Juli 1991, STUTTGART - DE Seiten 406 - 414, XP000267526 STÖCKER ET AL. 'ZUVERLÄSSIGKEIT VON ELEKTRONISCHEN BAUTEILE IM AUTOMOBIL'

## Beschreibung

Die Erfindung bezieht sich auf eine für Kraftfahrzeug-Bremsanlagen mit Blockierschutz-(ABS) und/oder Antriebsschlupfregelung (ASR) vorgesehene Regelschaltung, mit einem Ein-Chip-Microcontroller zur Auswertung und Verarbeitung von Daten, die mit Sensoren gewonnen werden und die das Drehverhalten der einzelnen Fahrzeugräder wiedergeben, und zur Erzeugung von Bremsdruck-Steuersignalen, die in die Druckmittelwege der Bremsanlage eingefügten, elektrisch umschaltbaren Hydraulikventilen zugeführt werden, und/oder zur Erzeugung von Motormoment-Steuersignalen, wobei der Microcontroller bei jedem Einschalten oder in Abhängigkeit von anderen regelmäßig wiederkehrenden Ereignissen sowie zyklisch wiederholt während des Betriebs durch Tests, Selbsttests, Signaturanalyse der Festwertspeicher und/oder nach anderen an sich bekannten Methoden der Fehlererkennung ständig überprüft wird, und mit einem Überwachungsschaltkreis, der im Störfall die Regelung teilweise oder vollständig stillegt oder abschaltet.

Eine Regelschaltung dieser Art ist aus der EP-A 0 357 922 bekannt. Beschrieben ist in dieser Schrift ein Verfahren zum Betrieb einer Betriebsbremseinrichtung für ein Nutzfahrzeug und ein elektronisches Steuergerät zur Durchführung des Verfahrens. Zur Auswertung und Verarbeitung der mit Sensoren gewonnen Daten wird ein hochintegrierter Ein-Chip-Microcontroller verwendet, der auch Pulbreitenmodulatoren zur Erzeugung der Ventilsteuersignale enthält. Ein integraler Bestandteil des Microrechners ist ein ROM-programmiertes Test-Modul, das einen zyklisch sich wiederholenden Selbsttest durchführt, welcher alle wichtigen Funktionen und Operationen des Microcontrollers einschließt, außerdem enthält das Steuergerät einen Überwachungsschaltkreis, der bei bestimmten Störungen den Microcontroller in einen Initialisierungszustand zurücksetzt.

In der DE 32 34 637 C2 ist eine Regelschaltung für ein ABS bekannt, bei der die von Radsensoren stammenden Signale in zwei voneinander unabhängigen parallelen identisch aufgebauten und identisch programmierten Microcontrollern verarbeitet werden. Die Ausgangssignale beider Microcontroller werden auf Übereinstimmung überprüft. Treten Abweichungen auf, wird die Regelung stillgelegt oder abgeschaltet, damit die Bremsanlage, wenn auch ohne Regelung, funktionsfähig bleibt. Diese bekannte Regelschaltung beruht also auf einer redundanten Signalverarbeitung in zwei kompletten Schaltkreisen, wobei die Redundanz allein dem Zweck dient, auftretende Fehler mit hoher Sicherheit zu erkennen und die Regelung im Fehlerfalle auszuschalten. Die Ausschaltmechanismen sind ebenfalls aus gleichem Grund weitgehend redundant aufgebaut.

Es bedarf keiner näheren Erläuterung, daß die redundante Signalverarbeitung mit Hilfe parallel betriebener vollständiger Microcontroller einen erheblichen Aufwand darstellt.

Eine andere bekannte Schaltungsanordnung dieser Art, die in der DE 41 37 124 A1 beschrieben ist, sieht ebenfalls vor, die Sensorsignale bzw. Eingangssignale parallel zwei Schaltkreisen zuzuführen, von denen jedoch nur einer die vollständige, aufwendige Signalverarbeitung ausführt. Der zweite Schaltkreis dient vornehmlich zur Überwachung, weshalb die Eingangssignale nach Aufbereitung und Bildung von Ableitungen mit Hilfe vereinfachter Regelalgorithmen und vereinfachter Regelphilosophie weiterverarbeitet werden. Die vereinfachte Verarbeitung reicht zur Erzeugung von Signalen aus, die durch Vergleich mit den in dem aufwendigeren Microcontroller verarbeiteten Signalen Rückschlüsse auf ordnungsgemäßen Betrieb zulassen.

Die Signalverarbeitung mit Hilfe dieser bekannten Schaltung ist ebenfalls noch weitgehend redundant, wenn auch mit Einschränkungen. Neben dem aufwendigen Microcontroller zur eigentlichen Signalverarbeitung ist ein zweiter integrierter Schaltkreis für die immer noch komplexe, wenn auch vereinfachte Nachbildung der Regelalgorithmen erforderlich.

Der Erfindung liegt nun die allgemeine Aufgabe zugrunde, den erforderlichen Aufwand für die Regelschaltung der eingangs genannten Art noch stärker zu reduzieren, ohne jedoch Zugeständnisse an die Zuverlässigkeit der Regelung und Sicherheit der Fehlererkennung machen zu müssen. Da natürlich auch bisher nicht alle Fehlerarten erfaßt werden konnten, wurde sogar eine weitere Erhöhung der Sicherheit angestrebt.

Es hat sich gezeigt, daß diese Aufgabe durch eine Regelschaltung der vorgenannten Art gelöst werden kann, deren Besonderheit darin besteht, daß mit Hilfe des Ein-Chip-Microcontrollers die Daten in mindestens zwei, zeitlich nacheinander oder zeitlich versetzt ablaufenden Rechenprozessen, die zumindest teilweise nach unterschiedlichen Algorithmen durchgeführt werden, verarbeitet werden, und daß die Ergebnisse und/oder Zwischenergebnisse der Rechenprozesse zwischengespeichert, verglichen und auf Übereinstimmung geprüft werden und daß Abweichungen zwischen den Rechenergebnissen bzw. Zwischenergebnissen dem Überwachungsschaltkreis signalisiert werden.

Während man bisher die Redundanz der Signalverarbeitung (sogenannte "passive" Redundanz zur sicheren Abschaltung im Fehlerfall) als unverzichtbares Merkmal einer für Bremsanlagen geeigneten Regelschaltung ansah und dementsprechend einen Aufbau der Regelschaltung mit zwei parallelen Datenverarbeitungsschaltungen für erforderlich hielt, wird erfindungsgemäß vorgeschlagen, auf diese Art der Redundanz zu verzichten. Statt dessen werden zwei verschiedenartige Rechenprozesse, die zu dem gleichen Ergebnis führen müssen, in einem einzigen Microcontroller nacheinander oder zeitlich versetzt durchgeführt und die Ergebnisse beider Berechnungsvorgänge verglichen. Der Microcontroller wird außerdem durch Anwendung an sich bekannter Methoden der Fehlererkennung ständig auf Funktionsfähigkeit überprüft.

Durch die erfindungsgemäße Ausgestaltung der Regelschaltung wird eine Reduzierung des Schaltungsaufwandes - es ist nur noch ein Microcontroller erforderlich - und dennoch eine mit den bekannten Schaltungen vergleichbare oder sogar verbesserte Sicherheit gegenüber Fehlfunktionen erreicht. Bei der Verwendung von parallel angesteuerten, identisch programmierten Microcontrollern ist es nämlich möglich, daß während des Betriebs in beiden Schaltkreisen zeitgleich der gleiche Fehler auftritt. Dies kann z.B. auf Maskenfehler zurückgehen, die bei zwei der gleichen Charge entnommenen integrierten Schaltkreisen zu dem gleichen Effekt führen. Bei Datenverarbeitung nach verschiedenen Algorithmen werden auch solche Prozessorfehler erkannt.

Verschiedenartige, an sich bekannte Methoden der Fehlererkennung, die mit Hilfe der Software realisiert werden, dienen zur ständigen Überprüfung des gesamten Microcontrollers. Selbsttests bei jedem Einschalten des Controllers, Überprüfung der Festwertspeicher (ROM) während des Betriebs mittels sogenannter Signaturanalyse sowie Überprüfung der Speicher mit variablem Inhalt (RAM) mittels Testmustern auf statische und dynamische Fehler sind nur einige der bekannten, zur Fehlererkennung anwendbaren Methoden.

Nach einem Ausführungsbeispiel der Erfindung werden die Rechenprozesse, mit denen die Eingangsdaten verarbeitet werden, zumindest teilweise durch Zugriff auf in Tabellen gespeicherte Werte ausgeführt. Es werden also z.B. errechnete Ergebnisse mit aus Tabellen entnommenen Daten verglichen. Bei Datenverarbeitungsfehlern treten zwangsläufig Unterschiede auf.

Eine weitere Ausführungsart der Erfindung besteht darin, daß der Microcontroller bei ordnungsgemäßem Arbeiten der Regelschaltung und ordnungsgemäßen Verhalten der von dem Microcontroller überwachten Funktionen dem Überwachungsschaltkreis ein Wechselsignal, z.B. ein Pulsfolgesignal bestimmter Frequenz und Signalform zuleitet. Liegt kein Fehler vor, müssen die Kennwerte des Wechselsignals, z.B. Frequenz, Pulsdauer und Pulspausen, innerhalb vorgegebener Grenzwerte liegen.

Es ist auch möglich, anstelle des Wechselsignals ein numerisches Signal zu verwenden, um das ordnungsgemäße Arbeiten des Microcontrollers bzw. das Vorliegen von Fehlern dem Überwachungsschaltkreis zu signalisieren.

Ein anderer Weg zur Fehlererkennung besteht darin, daß die Eingangssignale des Microcontrollers, die Rechenergebnisse und/oder die Zwischenergebnisse auf Plausibilität geprüft werden und daß "an sich nicht mögliche" Signale, Ergebnisse oder -kombinationen dem Überwachungsschaltkreis als Fehler signalisiert werden.

Eine weitere vorteilhafte Ausführungsart der Erfindung besteht darin, daß in die Überwachung durch den Microcontroller oder durch den Überwachungsschaltkreis die elektrischen Kennwerte der von dem Microcontroller gesteuerten Hydraulikventile, die Höhe der Versorgungsspannungen für die Hydraulikventile und für die elektronischen Schaltkreise sowie der Zustand der für die Abschaltung der Regelung im Fehlerfalle vorgesehenen Schalter einbezogen sind. Außerdem werden zweckmäßigerweise mit Hilfe des Microcontrollers und/oder des Überwachungsschaltkreises die Anschlußleitungen und der elektrische Teil der Hydraulikventile auf Leitungsunterbrechung, Kurzschluß oder Leckströme überwacht. Andere Teile der Regelschaltung, wie Taktgeber, Timer usw. können ebenfalls in bekannter Weise in die Überwachung einbezogen werden.

Weiterhin ist es zweckmäßig, den Überwachungsschaltkreis durch einen Einschalt- oder Abschalttest und/oder durch von dem Microcontroller ausgelöste Testsignale auf Funktionsfähigkeit zu prüfen. Es werden also alle Kreise, auch die Prüfkreise selbst, in die Tests einbezogen.

Nach einer weiteren wichtigen Ausführungsart der Erfindung werden die auftretenden Fehlfunktionen von dem Microcontroller und/oder dem Überwachungsschaltkreis bewertet, und es wird die Regelung erst dann stillgelegt oder abgeschaltet, wenn die Dauer der Fehlfunktionen oder die Häufigkeit pro Zeiteinheit vorgegebene Toleranzschwellen überschreiten. Kurzzeitige Fehlfunktionen haben nämlich im allgemeinen keinen oder einen vernachlässigbaren Einfluß auf die Bremswirkung. Relativ harmlose oder selten auftretende Fehler sollten zumindest signalisiert werden. Schwerwiegendere Fehler, die die Bremsenfunktion gefährden könnten, führen zum Abschalten der Regelschaltung. Die Reaktion auf Fehler kann auch davon abhängig gemacht werden, ob gerade ein ABS- oder ASR-Regelvorgang läuft oder ob im betrachteten Augenblick keine Regelung stattfindet.

Weitere Merkmale, Vorteile und Anwendungsmöglichkeiten der Erfindung gehen aus der folgenden Beschreibung von Ausführungsbeispielen anhand der beigefügten Abbildungen hervor.

Es zeigen
- Fig. 1: im Blockschaltbild die wesentlichen Komponenten einer Regelschaltung nach der Erfindung,
- Fig. 2: in weiteren Details den Aufbau des Microcontrollers der Regelschaltung nach Fig. 1,
- Fig. 3: das Ablaufdiagramm der Überprüfung von Rechenergebnissen auf Übereinstimmung im Microcontroller der Regelschaltung nach Fig. 1,
- Fig. 4: das Ablaufdiagramm einer Fehlererkennung durch zyklische Signaturanlayse.

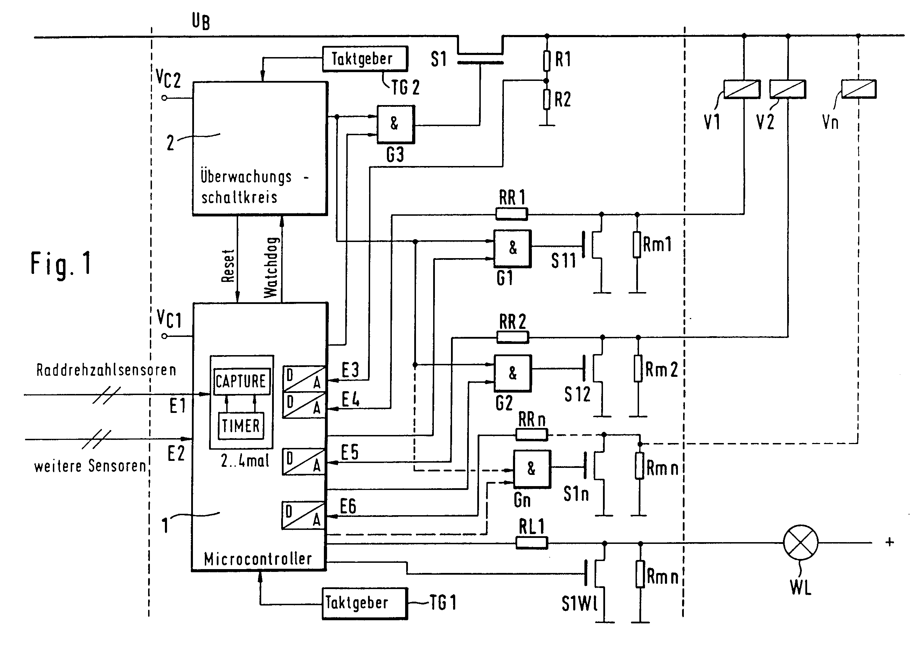

Wichtige Bausteine einer Regelschaltung nach der Erfindung sind gemäß Fig. 1 ein Ein-Chip-Microcontroller 1, ein Überwachungsschaltkreis 2, ein Halbleiterschalter oder ein Relais S1 zum Ein- und Ausschalten der Stromversorgung für die Ventilspulen V1,V2,Vn von (nicht dargestellten) Hydraulikventilen sowie die Halbleiterschalter bzw. Transistoren S11,S12,S1n zur Ansteuerung der Ventilspulen V1,V2,Vn. Im Ansteuerweg dieser Transistoren S11,S12,S1n befinden sich UND-Gatter G1,G2,Gn mit jeweils zwei Eingängen, über die diese Gatter zum einen an den Microcontroller 1, zum anderen an den Überwachungsschaltkreis 2 angeschlossen sind. Ferner ist in Fig. 1 noch ein Ansteuertransistor S1Wl für eine Warnlampe WL, Taktgeber TG1,TG2 zur Erzeugung der Arbeitstakte für die beiden integrierten Schaltkreise, nämlich für den Microcontroller 1 und für den Überwachungsschaltkreis 2. Mehrfach-Leitungen, die dem Microcontroller über die Eingänge E1,E2 die Radsensorsignale (über E1) und weitere Informationen (über E2) zuführen, sind ebenfalls in Fig. 1 dargestellt. Zur Spannungsversorgung des Microcontrollers 1 und des Überwachungsschaltkreises 2 dienen die Anschlüsse V_{C1} bzw V_{C2}, während die Spannungsversorgung der Ventile V1,V2,Vn aus der Batterie U_{B} über den Halbleiterschalter S1 erfolgt.

Außerdem ist im Ansteuerweg des Halbleiterschalters S1 noch ein UND-Gatter G3 vorgesehen, das ein Ansteuersignal für den Halbleiterschalter S1 nur dann weitergibt, wenn sowohl der Überwachungsschaltkreis 2 als auch der Microcontroller 1 einwandfreies Funktionieren erkennen und eine entsprechendes Signal zur Ansteuerung des Schalters S1 über das UND-Gatter G3 liefern.

Der Mittenabgriff eines Spannungsteilers R1,R2 führt zu einem Eingang E3 des Microcontrollers 1. Über diesen Eingang prüft der Microcontroller das Vorhandensein und die Höhe der zur Versorgung der Ventilspulen V1,V2,Vn dienenden Spannung. Über die Eingänge E4,E5,E6 wird dem Microcontoller 1 der Schaltzustand der Ventil-Ansteuertransistoren S11,S12,S1n gemeldet. Eine Leitungsunterbrechung, einen Kurzschluß oder (erhöhter) Leckstrom auf dem Weg zu den Ventilspulen V1,V2,Vn ist ebenfalls über die Eingänge E4 bis E6 erkennbar. Durch logische Verknüpfung der Eingangssignale und Vergleich mit den Ventilansteuersignalen lassen sich weitere Überwachungsvorgänge realisieren.

Microcontroller 1 und Überwachungsschaltkreis 2 sind durch in beide Richtungen führende Signalleitungen miteinander verbunden. Über die Leitung WD ("watch dog") wird dem Überwachungsschaltkreis 2 von dem Microcontroller 1 durch ein Wechselsignal oder durch ein numerisches Signal eine Information über das ordnungsgemäße Arbeiten und den ordnungsgemäßen Zustand des Microcontrollers 1 und der von diesem Microcontroller überwachten Funktionen, von denen einige bereits oben genannt sind, zugeführt. Das Überwachungssignal WG bzw. dessen Frequenz, Pulsform oder numerischer Inhalt liegen nur dann innerhalb vorgegebener Grenzwerte, wenn keinerlei Fehlfunktionen festgestellt werden. Außerdem ist es möglich, die über die Eingänge E1,E2 zugeführten Informationen und Meßwerte, die vor allem das Drehverhalten der einzelnen Räder beinhalten, auf Plausibilität zu überprüfen.

Geben die Meßwerte oder Meßwertkombinationen Zustände wieder, die nicht "plausibel" sind, weil sie beispielsweise physikalisch nicht möglich sind, muß ein Fehler vorliegen, der über das Überwachungssignal WG dem Überwachungskreis gemeldet wird. Je nach Auslegung der Überwachung, führt ein Fehler entweder sofort zum Abschalten der Regelung, oder der auftretende Fehler wird "bewertet" und löst je nach Ergebnis der Bewertung unterschiedliche Reaktionen aus; manche Fehler sind kurzzeitig tolerierbar, andere stellen eine Gefahr für die Fahrstabilität oder die Bremsenfunktion dar und verlangen daher ein sofortiges Abschalten der Regelung. Es sind zahlreiche Varianten, bezogen auf Fehlerart und Reaktion, denkbar.

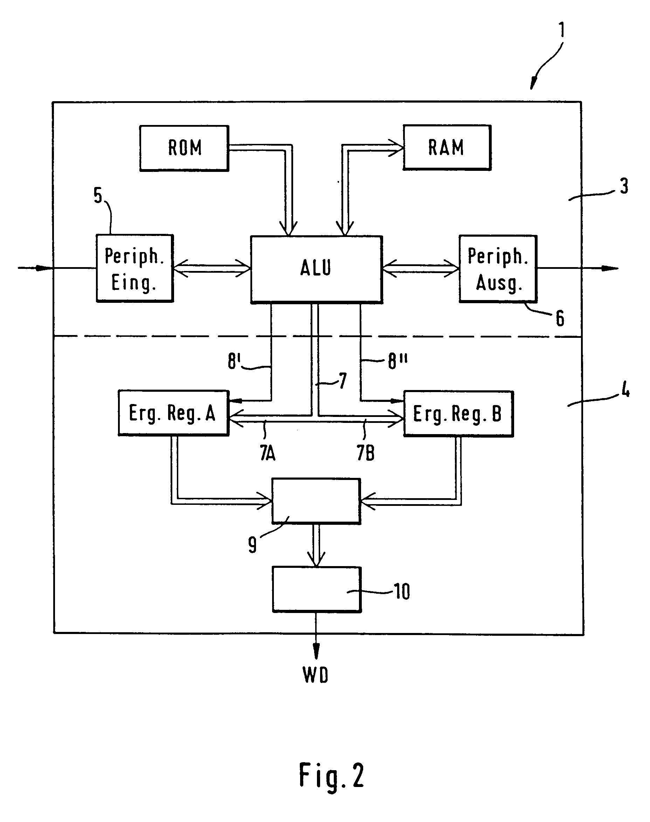

Ein weiteres wesentliches Merkmal der erfindungsgemäßen Regelschaltung wird nun anhand der Fig. 2 in Verbindung mit Fig. 1 erläutert. Die einzelnen, teilweise sehr aufwendigen Rechenprozesse oder Algorithmen, in denen die sogen. Regelphilosophie steckt und die im Rahmen einer Blockierschutz- oder Antriebsschlupfregelung zur Erzeugung der Ventilsteuersignale in Abhängigkeit von den Eingangssignalen erforderlich sind, werden erfindungsgemäß in dem Microcontroller mindestens zweimal nacheinander oder zeitlich versetzt durchgeführt. Dabei werden zumindest für einen Teil der nacheinander oder zeitlich versetzt ablaufenden Rechenprozesse, die zu den gleichen Ergebnissen oder Zwischenergebnissen führen müssen, unterschiedliche Rechenwege bzw. Algorithmen gewählt, wobei auch auf tabellierte Werte zurückgegriffen werden kann. Diese Anwendung verschiedener Rechenwege oder Algorithmen für die gleichen Rechenprozesse hat zur Folge, daß die Ergebnisse oder Zwischenergebnisse nicht mehr übereinstimmen, wenn der Microcontroller Strukturfehler oder Programmierfehler aufweist oder aus anderen Gründen fehlerhaft wird.

Nach Fig. 2 setzt sich der Microcontroller 1 der erfindungsgemäßen Regelschaltung aus dem eigentlichen Rechner-Hauptteil 3 und aus Zusatzschaltkreisen 4 zusammen. Die gestrichelte, waagrechte Trennlinie symbolisiert diese Unterscheidung. Zu dem Rechner-Hauptteil gehören die Rechnereinheit ALU, ein Festwertspeicher ROM und ein Speicher RAM variablen Inhalts. Außerdem sind Peripherie-Eingangsschaltkreise 5 und Peripherie-Ausgangsschaltkreise 6 vorhanden, über die die Eingangssignale zugeführt bzw. die Ausgangssignale abgeleitet werden. Die genannten Bausteine sind untereinander durch Signalleitungen verbunden, deren Übertragungsrichtung bzw. -richtungen durch Pfeile in Fig. 2 angedeutet sind.

In dem Microcontroller-Bestandteil mit den Zusatzschaltkreisen 4 befinden die erfindungswesentlichen Ergebnisregister A und B, in die die Ergebnisse und/oder Zwischenergebnisse der zeitlich nacheinander oder zeitlich versetzt ablaufenden Rechenprozesse eingeschrieben werden. Die von dem Rechner ALU des Microcontroller-Hauptteils 3 zu den Ergebnisregistern A,B führenden Signalleitungen oder der Datenbus sind in Fig. 2 mit 7,7A und 7B bezeichnet. Die Speicherbefehle werden jeweils über Leitungen 8',8'' zu dem Register A bzw. B übertragen.

Die Inhalte der Register A und B werden einem Vergleicher 9 zugeführt, der vollständige oder mangelnde Übereinstimmung oder Abweichungen zwischen den verglichenen Signalen feststellt und dessen Ausgangssignal schließlich in einer Einheit 10 ausgewertet wird. Das ausgewertete Vergleichsergebnis bestimmt schließlich den Inhalt oder die kennzeichnenden Merkmale des Überwachungssignals WD, das - siehe Fig. 1 - dem Überwachungsschaltkreis 2 zugeleitet wird. Natürlich können in der Auswerteeinheit 10 noch die anderen Prüfvorgänge, beispielsweise über die über die Eingänge E3 bis E6 zugeführten Informationen und Prüfergebnisse, vor Bildung des Überwachungssignals WD berücksichtigt werden.

Bei der Auswertung der Vergleichsergebnisse, die mit Hilfe der Einheit 10 des Microcontrollers 1 und/oder im Überwachungsschaltkreis 2 erfolgen kann, werden die auftretenden Fehler oder Abweichungen zweckmäßigerweise nach Art, Dauer oder Häufigkeit und Bedeutung des Fehlers für die Regelung bewertet. Vom Ergebnis dieser Bewertung hängt es ab, ob die Regelung sofort oder verzögert, vorübergehend oder auf Dauer stillgelegt oder abgeschaltet wird.

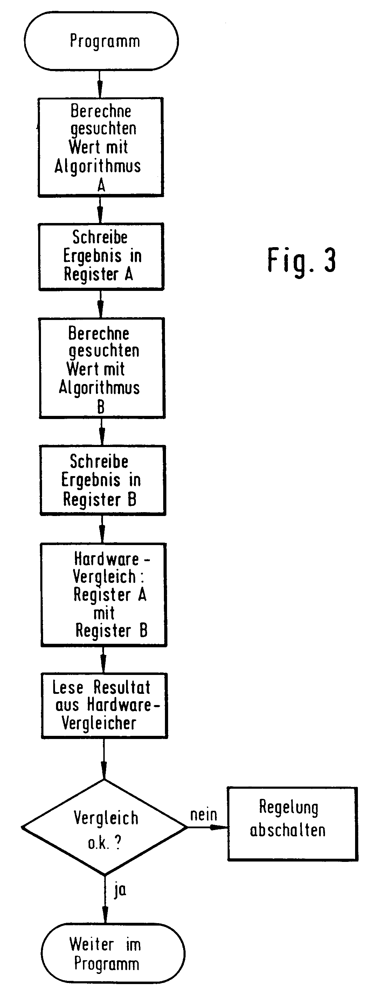

Das Ablaufdiagramm nach Fig. 3 veranschaulicht nochmals in vereinfachter Form den erfindungswesentlichen Programmteil, der mit Hilfe der anhand der Fig. 2 beschriebenen Ergebnisregister A und B durchgeführt wird. Die einzelnen Schritte und Befehle sind in Fig. 3 angegeben. Stellen sich beim Vergleich keine Abweichungen heraus, läuft das Rechenprogramm weiter; anderenfalls ergeht der Befehl zur Abschaltung der Regelung.

Zur Sicherheit und Zuverlässigkeit der erfindungsgemäßen Regelschaltung tragen außerdem die Anwendung bekannter Software-Methoden zur Erkennung von Fehlern im Inneren des Microcontrollers bei. Es werden bei jedem Einschalten oder Abschalten des Microcontrollers oder in Abhängigkeit von anderen regelmäßig wiederkehrenden Ereignissen, in vorgegebenen Zeitabständen usw. sowie zyklisch wiederholt während des Betriebs Tests, Selbsttests, Signaturanalysen usw. bekannter Art durchgeführt. Durch Überprüfung des Festwertspeicher-Inhalts mittels der bekannten Signaturanalyse, hierauf bezieht sich das Ablaufdiagramm nach Fig. 3, lassen sich fehlerbedingte Informationsänderungen im Festwertspeicher (ROM) erkennen. Bei Speicher mit variablem Inhalt (RAM) lassen sich statische und dynamische Fehler beim Adressieren, Speichern und Lesen durch bekannte Methoden der Überprüfung mittels Testmustern erkennen. Hierzu wird beispielsweise in einen einheitlich vorbelegten Speicher ein inverses Element eingeschrieben, und anschließend werden alle anderen Elemente auf korrekten Inhalt überprüft. Nach jedem Lesezugriff auf eine der Zellen wird die Testzelle wiederum überprüft. Dieser Vorgang wird für alle Zeichen wiederholt. Ein zweiter Durchlauf wird mit der inversen Vorbelegung des gesamten Speichers durchgeführt.

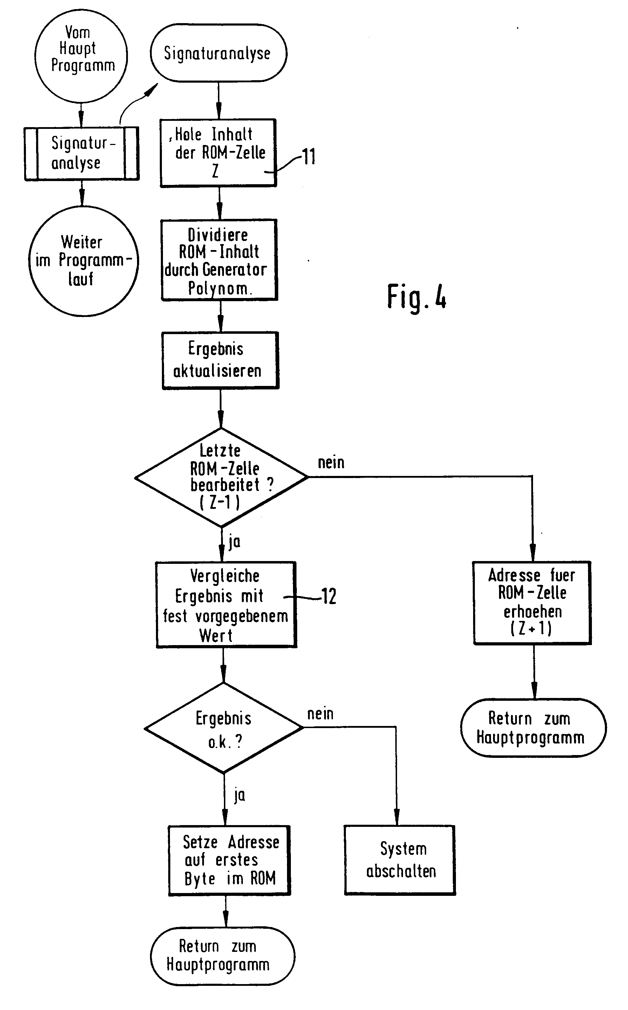

Das Ablaufdiagramm nach Fig. 4 veranschaulicht die einzelnen Schritte der zyklisch wiederholt durchgeführten Signaturanalyse zur Überprüfung eines Festwertspeichers. Zu bestimmten Zeiten, in denen der Programmlauf dies zuläßt, wird von dem Hauptprogramm die Signaturanalyse gestartet. Die einzelnen Programmschritte, deren Reihenfolge und die Entscheidungsstellen sind in Fig. 4 angegeben. Der dargestellte Ablauf von Befehl 11 ("hole Inhalt der zu prüfenden ROM-Zelle") bis zum Befehl 13 ("zurück zum Hauptprogramm") wird für alle ROM-Speicherzellen nacheinander wiederholt. Im Programmschritt 12 wird zur Fehlererkennung das Ergebnis mit einem vorgegebenen, festprogrammierten Wert verglichen.

Mit anderen zyklischen Tests wird das Funktionieren der Timer, dessen Zeitverhalten, die korrekte Bildung von Inkrement oder Dekrement usw. überprüft.

Die Ergebnisse aller Tests werden schließlich über das Überwachungssignal WD erfaßt und dem Überwachungsschaltkreis 2 gemeldet.

Erfindungsgemäß wird also eine Regelschaltung auf Basis eines einzigen Microcontrollers in Verbindung mit einem Überwachungsschaltkreis geschaffen. Durch die erfindungswesentliche Datenverarbeitung, nämlich durch zeitlich nacheinander oder zeitlich versetzt ablaufende Rechenprozesse nach unterschiedlichen Algorithmen in Verbindung mit regelmäßig wiederkehrenden und zyklisch wiederholten Tests, wird das sofortige Erkennen und Signalisieren von Fehlern unterschiedlicher Art sichergestellt.

## Patentansprüche

1. Regelschaltung für Kraftfahrzeug-Bremsanlagen mit Blockierschutz-(ABS) und/oder Antriebsschlupfregelung (ASR), mit einem Ein-Chip-Microcontroller (1) zur Auswertung und Verarbeitung von Daten, die mit Sensoren gewonnen werden und die das Drehverhalten der einzelnen Fahrzeugräder wiedergeben, und zur Erzeugung von Bremsdruck-Steuersignalen, die in die Druckmittelwege der Bremsanlage eingefügten, elektrisch umschaltbaren Hydraulikventilen zugeführt werden, und/oder zur Erzeugung von Motormoment-Steuersignalen, wobei der Microcontroller (1) bei jedem Einschalten oder in Abhängigkeit von anderen regelmäßig wiederkehrenden Ereignissen sowie zyklisch wiederholt während des Betriebs durch Tests, Selbsttests, Signaturanalyse der Festwertspeicher und/oder nach anderen an sich bekannten Methoden der Fehlererkennung ständig überprüft wird, und mit einem Überwachungsschaltkreis (2), der im Störfall die Regelung teilweise oder vollständig stillegt oder abschaltet, dadurch **gekennzeichnet**, daß mit Hilfe des Ein-Chip-Microcontrollers (1) die Daten in mindestens zwei, zeitlich nacheinander oder zeitlich versetzt ablaufen-den Rechenprozessen, die zumindest teilweise nach unterschiedlichen Algorithmen durchgeführt werden, verarbeitet werden, daß die Ergebnisse und/oder Zwischenergebnisse der Rechenprozesse zwischengespeichert, verglichen und auf Übereinstimmung geprüft werden und daß Abweichungen zwischen den Rechenergebnissen bzw. Zwischenergebnissen dem Überwachungsschaltkreis (2) signalisiert werden.

2. Regelschaltung nach Anspruch 1, dadurch **gekennzeichnet,** daß die Rechenprozesse zumindest teilweise durch Zugriff auf in Tabellen gespeicherte Werte ausgeführt werden.

3. Regelschaltung nach Anspruch 1 oder 2, dadurch **gekennzeichnet,** daß der Microcontroller (1) bei ordnungsgemäßem Arbeiten der Regelschaltung und ordnungsgemäßem Verhalten der von dem Microcontroller (1) überwachten Funktionen dem Überwachungsschaltkreis (2) ein Wechselsignal (WD) bestimmter Frequenz und Signalform zuleitet.

4. Regelschaltung nach Anspruch 3, dadurch **gekennzeichnet,** daß das Wechselsignal (WD) ein Pulsfolgesignal ist, dessen Pulszeiten und Pulspausenzeiten bei ordnungsgemäßer Funktion innerhalb vorgegebener Grenzwerte liegen.

5. Regelschaltung nach Anspruch 1 oder 2, dadurch **gekennzeichnet,** daß der Microcontroller (1) das ordnungsgemäße Arbeiten der Regelschaltung und der von dem Microcontroller (1) überwachten Funktionen dem Überwachungsschaltkreis (2) durch numerische Signale anzeigt.

6. Regelschaltung nach einem oder mehreren der Ansprüche 1 bis 4, dadurch **gekennzeichnet,** daß die Eingangssignale des Microcontrollers (1), Rechenergebnisse und/oder Zwischenergebnisse auf Plausibilität geprüft werden und daß das Auftreten von "an sich nicht möglichen" Signalen, Ergebnissen oder -kombinationen als Fehler bewertet und dem Überwachungsschaltkreis (2) signalisiert wird.

7. Regelschaltung nach einem oder mehreren der Ansprüche 1 bis 6, dadurch **gekennzeichnet,** daß in die Überwachung durch den Microcontroller (1) der Zustand und die Funktion der von dem Microcontroller (1) angesteuerten Hydraulikventile, die Höhe der Versorgungsspannungen (U_{B},V_{c1},V_{c2}) für die Hydraulikventile und für die elektronischen Schaltkreise (1,2) sowie der Zustand eines oder mehrerer für die Abschaltung der Regelung vorgesehenen Schalter (S1) einbezogen sind.

8. Regelschaltung nach einem oder mehreren der Ansprüche 1 bis 7, dadurch **gekennzeichnet,** daß mit Hilfe des Microcontrollers (1) und/oder des Überwachungsschaltkreises (2) die Anschlußleitungen und/oder der elektrische Teil der Hydraulikventile auf Leitungsunterbrechung, Kurzschluß und Leckströme überwacht werden.

9. Regelschaltung nach einem oder mehreren der Ansprüche 1 bis 8, dadurch **gekennzeichnet,** daß durch einen Einschalt- oder Abschalttest und/oder durch von dem Microcontroller (1) ausgelöste Testsignale der Überwachungsschaltkreis auf Funktionsfähigkeit geprüft wird.

10. Regelschaltung nach einem oder mehreren der Ansprüche 1 bis 9, dadurch **gekennzeichnet,** daß der Microcontroller (1) und/oder der Überwachungsschaltkreis (2) die auftretenden Fehlfunktionen bewertet und die Regelung erst dann stillegt oder abschaltet, wenn die Dauer der Fehlfunktion oder deren Häufigkeit pro Zeiteinheit vorgegebene Toleranzschwellen überschreiten.

11. Regelschaltung nach einem oder mehreren der Ansprüche 1 bis 10, dadurch **gekennzeichnet,** daß der Microcontroller (1) und/oder der Überwachungsschaltkreis (2) die auftretenden Fehlfunktionen bewertet und die Regelung erst abschaltet, wenn eine die Bremswirkung gefährdende Fehlfunktion auftritt.

## Claims

1. A control circuit for use in automotive vehicle brake systems with anti-lock control (ABS) and/or traction slip control (TCS) systems, including a single-chip microcontroller (1) for evaluating and processing data obtained by sensors and representative of the rotational behavior of the individual vehicle wheels, and for generating braking pressure control signals which are delivered to electrically commutable hydraulic valves inserted into the pressure fluid conduits of the brake system, and/or for generating engine torque control signals, wherein the microcontroller (1) is constantly checked on each activation, or as a function of other periodic events, and cyclically repeated during operation, by way of tests, self-tests, a signature analysis of the read-only memories and/or according to other per se known methods of error detection, and including a monitoring circuit (2) which deactivates or disconnects the control partially or entirely in the case of an interference,
**characterized** in that the single-chip microcontroller (1) processes the data in at least two successive or time-offset calculating operations, which are performed at least in part according to different algorithms, in that the results and/or the intermediate results of the calculating operations are temporarily stored, compared and checked for coincidence, and in that differences in the calculation results or the intermediate results are signalled to the monitoring circuit (2).

2. A control circuit as claimed in claim 1,
**characterized** in that the calculating operations are performed at least in part by using values stored in tables.

3. A control circuit as claimed in claim 1 or claim 2,
**characterized** in that the microcontroller (1) delivers an alternating signal (WD) of a defined frequency and signal shape to the monitoring circuit (2) in fail-free operation of the control circuit and due performance of the functions monitored by the microcontroller (1).

4. A control circuit as claimed in claim 3,
**characterized** in that the alternating signal (WD) is a pulse train signal, and the pulse times and times of pulse pause of the signal are within the range of predetermined limit values, with proper function of the control circuit.

5. A control circuit as claimed in claim 1 or claim 2,
**characterized** in that the microcontroller (1) issues numerical signals to the monitoring circuit (2) to indicate the fail-free operation of the control circuit and the functions monitored by the microcontroller (1).

6. A control circuit as claimed in any one or more of claims 1 to 4,
**characterized** in that the input signals of the microcontroller (1), the calculation results and/or the intermediate results are checked for plausibility, and in that the occurrence of "hardly possible" signals, results or result combinations is rated as an error and signalled to the monitoring circuit (2).

7. A control circuit as claimed in any one or more of claims 1 to 6,
**characterized** in that the state and the function of the hydraulic valves actuated by the microcontroller (1), the magnitude of the supply voltages (U_{B}, V_{c1}, V_{c2}) for the hydraulic valves and for the electronic circuits (1, 2), and the condition of one or more of the switches (S1) used to disconnect the control is taken into account for the monitoring operation by the microcontroller (1).

8. A control circuit as claimed in any one or more of claims 1 to 7,
**characterized** in that the connecting lines and/or the electrical part of the hydraulic valves are checked for line interruptions, short-circuits or leakage currents by the microcontroller (1) and/or the monitoring circuit (2).

9. A control circuit as claimed in any one or more of claims 1 to 8,
**characterized** in that the monitoring circuit is checked for operability by a switch-on or switch-off test and/or by test signals issued by the microcontroller (1).

10. A control circuit as claimed in any one or more of claims 1 to 9,
**characterized** in that the microcontroller (1) and/or the monitoring circuit (2) evaluates the malfunctions and deactivates or disconnects the control if the duration of the malfunctions or the frequency of the malfunctions per time unit exceeds predetermined tolerance thresholds.

11. A control circuit as claimed in any one or more of claims 1 to 10,
**characterized** in that the microcontroller (1) and/or the monitoring circuit (2) evaluates the malfunctions and disconnects the control if a malfunction occurs which jeopardizes the braking effect.

## Revendications

1. Circuit de régulation pour des installations de freinage de véhicules automobiles comportant un système de régulation d'antiblocage (ABS) et/ou un système de régulation du patinage (ASR), un microcontrôleur monopuce (1) pour exploiter et traiter des données, qui sont fournies par des capteurs et qui reproduisent le comportement de rotation des roues individuelles du véhicule, et pour produire des signaux de commande de la pression de freinage, qui sont envoyés à des soupapes hydrauliques commutables électriquement insérées dans les voies de circulation du fluide sous pression de l'installation de freinage et/ou pour produire des signaux de commande du couple moteur, et dans lequel, lors de chaque activation ou en fonction d'autres évènements se reproduisant régulièrement ainsi que cycliquement de façon répétée pendant le fonctionnement, le microcontrôleur est contrôlé en permanence au moyen de tests, de tests automatiques, de l'analyse de signatures de la mémoire morte et/ou selon d'autres procédés connus en soi d'identification de défauts, et comportant un circuit de contrôle (2), qui dans le cas d'une perturbation, arrête partiellement ou complètement ou débranche le système de régulation, caractérisé en ce qu'à l'aide du microcontrôleur monopuce (1), les données sont traitées dans au moins deux processus de calcul qui se déroulent successivement ou d'une manière décalée dans le temps et qui sont exécutés au moins en partie selon des algorithmes différents, que les résultats et/ou les résultats intermédiaires des processus de calcul sont mémorisés temporairement, sont comparés et sont contrôlés pour déterminer s'ils sont coïncidants, et que des écarts entre les résultats de calcul et les résultats intermédiaires sont signalés au circuit de contrôle (2).

2. Circuit de régulation selon la revendication 1, caractérisé en ce que les processus de calcul sont exécutés au moins en partie par accès à des valeurs mémorisées dans des tableaux.

3. Circuit de régulation selon la revendication 1 ou 2, caractérisé en ce que dans le cas d'un fonctionnement correct du circuit de régulation et d'un comportement correct des fonctions contrôlées par le microcontrôleur (1), ce dernier envoie au circuit de contrôle (2) un signal alternatif (WD) possédant une fréquence et une forme déterminées.

4. Circuit de régulation selon la revendication 3, caractérisé en ce que le signal alternatif (WD) est un signal de train d'impulsions, dont les durées des impulsions et les durées de pause entre les impulsions sont situées, dans le cas d'un fonctionnement correct, entre des valeurs limites prédéterminées.

5. Circuit de régulation selon la revendication 1 ou 2, caractérisé en ce que le microcontrôleur (1) indique au circuit de contrôle (2), par des signaux numériques, le fonctionnement correct du circuit de régulation et des fonctions contrôlées par le microcontrôleur (1).

6. Circuit de régulation selon une ou plusieurs des revendications 1 à 4, caractérisé en ce qu'un contrôle de vraisemblance est appliqué aux signaux d'entrée du microcontrôleur (1), aux résultats de calcul et/ou aux résultats intermédiaires et que l'apparition de signaux de résultats ou de combinaisons de signaux et de résultats "impossibles en soi" est évaluée comme étant un défaut et est signalée au circuit de contrôle (2).

7. Circuit de régulation selon la revendication 1 à 6, caractérisé en ce que l'état et le fonctionnement des soupapes hydrauliques commandées, l'amplitude des tensions d'alimentation (U_{B}, V_{c1}, V_{c2}) pour les soupapes hydrauliques et pour les circuits électroniques (1,2) ainsi que l'état d'un ou de plusieurs interrupteurs (S1) prévus pour le débranchement du système de régulation sont insérés dans le contrôle effectué par le microcontrôleur (1).

8. Circuit de régulation selon une ou plusieurs des revendications 1 à 7, caractérisé en ce qu'une interruption de ligne, un court-circuit et des courants de fuite dans les lignes de connexion et/ou la partie électrique des soupapes hydrauliques sont contrôlés à l'aide d'un microcontrôleur (1) et/ou du circuit de contrôle (2).

9. Circuit de régulation selon une ou plusieurs des revendications 1 à 8, caractérisé en ce que l'aptitude au fonctionnement du circuit de contrôle est contrôlée au moyen d'un test de branchement ou de débranchement et/ou au moyen de signaux de test déclenchés par le microcontrôleur (1).

10. Circuit de régulation selon une ou plusieurs des revendications 1 à 9, caractérisé en ce que le microcontrôleur (1) et/ou le circuit de contrôle (2) évaluent les fonctions défectueuses, qui apparaissent, et arrêtent ou débranchent la régulation seulement lorsque la durée de la fonction défectueuse ou sa fréquence par unité de temps dépasse des valeurs des seuils de tolérance prédéterminés.

11. Circuit de régulation selon une ou plusieurs des revendications 1 à 10, caractérisé en ce que le microcontrôleur (1) et/ou le circuit de contrôle (2) évaluent les fonctions défectueuses, qui apparaissent, et débranchent la régulation uniquement lorsqu'apparait une fonction défectueuse qui met en danger l'action de freinage.
